# EUROPÄISCHE PATENTSCHRIFT

(11) **EP 0 357 888 B1**
(45) Veröffentlichungstag und Bekanntmachung des Hinweises auf die Patenterteilung: **29.12.1993**
(21) Anmeldenummer: 89110367.3
(22) Anmeldetag: 08.06.1989
(51) Int. Cl.: B66B 1/50, G01V 9/04, H03K 17/95

(54) **Verfahren und Vorrichtung für die Erzeugung einer Schachtinformation bei Aufzügen**
Method and device for generating lift shaft information
Méthode et dispositif pour générer une information d'une cage d'ascenseur

(30) Priorität: 23.08.1988 CH 3129/88
(43) Veröffentlichungstag der Anmeldung: 14.03.1990
(73) Patentinhaber: INVENTIO AG, CH-6052 Hergiswil NW (CH)
(72) Erfinder: Arnosti, Hansjörg, CH-6048 Horw (CH); Bussmann, Hans, CH-6030 Ebikon (CH)

(56) Entgegenhaltungen:
- DE-A- 1 809 100
- FR-A- 2 024 637
- US-A- 3 743 056

## Beschreibung

Die vorliegende Erfindung betrifft ein Verfahren und eine Vorrichtung zur Ausübung des Verfahrens zur Erzeugung einer Schachtinformation bei Aufzügen für die redundante und selbstprüfende Bildung von Signalen und Auslösung von Schaltfunktionen zwecks Ueberbrückung von Tür- und Schlosskontakten in der Türzone einer Zielhaltestelle bei in diese Haltestelle einfahrendem Aufzug.

Das vorzeitige Einleiten der Türöffnung beim Einfahren eines Aufzuges in eine Zielhaltestelle stellt hohe sicherheitstechnische Ansprüche an Einrichtungen und Schaltungen, welche innerhalb einer Türzone bei den Haltestellen die Tür- und Schlosskontakte beim Einfahren überbrücken. Es gibt Vorschriften und Normen, welche das Prinzip und die Hauptfunktionen solcher Vorrichtungen und Schaltungen vorschreiben bzw. empfehlen. Baugruppen solcher Vorrichtungen und Schaltungen welche diesen einschlägigen Sicherheitsbestimmungen entsprechen sind unter dem Begriff "Fail-Safe"-Baugruppe bekannt.

Eine solche Baugruppe ist im US-Patent US-A-3 743 056 als Fail-Safe-Detektor beschrieben. Der Erfindungsgegenstand ist ein optoelektronischer Reflex-Abtaster. Entsprechend positionierte Reflexplatten bzw. -Fahnen erzeugen eine Detektion und ein Nutzsignal. Das Nutzsignal wird durch Vergleich mit einem Referenzwert auf seine Echtheit geprüft und es muss in der Folge eine Schwellwertschaltung passieren, welche die Amplitudenhöhe prüft. Der Lichtsender ist gepulst und das Lichtempfängersignal muss einem Referenzwert entsprechen, womit Fremdlicht-Reflexe unwirksam bzw. erkannt werden. Ferner sind die Schaltungskomponenten so ausgewählt und ausgelegt, dass der Ausfall einzelner oder mehrerer Komponenten keine sicherheitsgefährdende Schaltfunktion zur Folge hätte.

Die beschriebene Vorrichtung hat den Nachteil der fehlenden Redundanz und dass die verschiedenen Schaltkreise dezentral angeordnet sind.

In der deutschen Offenlegungsschrift DE-A-1 809 100 wird ein Sicherheitgrenztaster beschrieben, welcher ein redundantes Sensorsystem besitzt, wobei bei jeder Betätigung des Initiators die Signale der beiden räumlich gestaffelt angeordneten Sensorsysteme mittels einer Prüflogik auf ihre zulässige zeitliche Staffelung geprüft werden und bei Ausfall eines Signales eine Störmeldung erzeugt wird; die Funktion eines verbleibenden Signals aber immer noch die ihm zugedachte Steuerfunktion ausübt. Ferner kann mit einer Rückführung des Verstärkerausganges in die Prüflogik die Funktionsfähigkeit des Initiators festgestellt und im Fehlerfalle ebenfalls das Fehlersignal erzeugt werden.

Dieser Initiator, welcher für die Steuerung einer Werkzeugmaschine vorgesehen ist, könnte für eine Sicherheits - Schachtinformation bei einem Aufzug nicht eingesetzt werden, weil das System nicht durchgehend redundant ist, ein Teilausfall keine Konsequenzen auf die Steuerung hat, die Selbstprüfung nicht den Aufzugsvorschriften entspricht.

Der vorliegenden Erfindung liegt die Aufgabe zugrunde, ein Verfahren und eine Vorrichtung zu schaffen, welche Redundanz aufweist, allen nationalen Vorschriften entspricht und eine kompakte Anordnung der Funktionskreise aufweist.

Diese Aufgabe wird durch die in den Ansprüchen gekennzeichnete Erfindung gelöst.

Die durch die Erfindung erreichten Vorteile sind im wesentlichen darin zu sehen, dass durch die kompakte Anordnung aller zugehörigen Funktionskreise nur ein einziges Apparategehäuse benötigt wird, dass durch die genannte Anordnung externe Zwischenverbindungen wegfallen, dass durch die genannte Anordnung das Verfahren und die Vorrichtung einfacher in der Handhabung und billiger in der Herstellung und Montage werden und dass durch interne Prüfschaltungen Fehler zeitlich vor deren Auswirkung erkannt und unschädlich gemacht werden.

In den Zeichnungen ist ein Ausführungsbeispiel der Erfindung dargestellt und es zeigen:
- Fig. 1: eine Sicherheitslichtschranke und ihre Anordnung im Sicherheitskreis,
- Fig. 2: eine Sicherheitslichtschranke und ihre Anordnung im Schacht,
- Fig. 3: ein Blockschaltbild der Funktionskreise in der Sicherheitslichtschranke und
- Fig. 4: Einzelheiten der Signalauswertung.

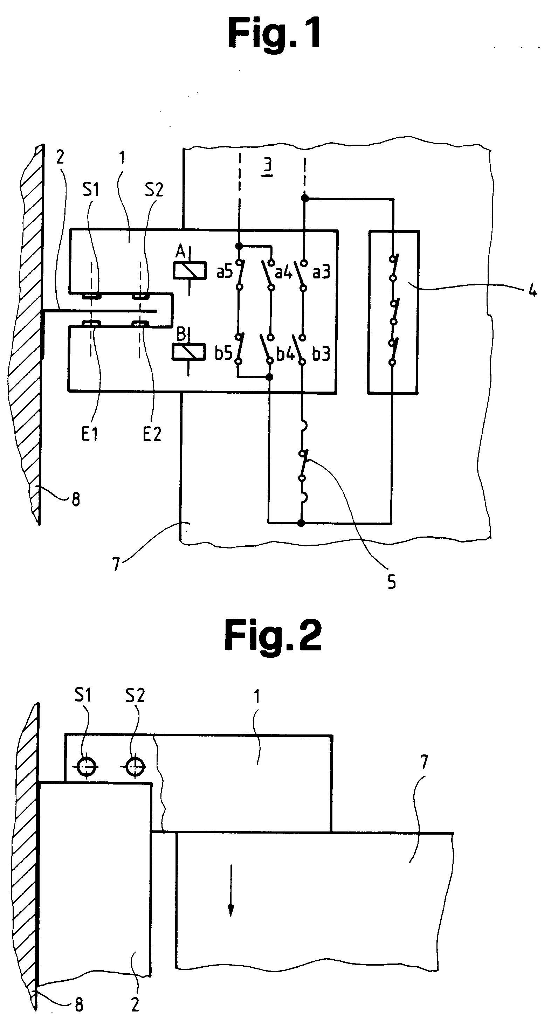

In der Fig. 1 ist mit 1 eine Sicherheitslichtschranke, mit 2 eine Betätigungsfahne und mit 3 ein Sicherheitskreis-Teilstück bezeichnet. S1 ist ein erster Sender und S2 ein zweiter Sender und E1 ein erster Empfänger und E2 ein zweiter Empfänger. A ist ein Türsicherheitsrelais mit Kontakten a3, a4 und a5 und B ist ein Türsicherheitsrelais mit Kontakten b3, b4 und b5. In Serie zu den Kontakten a3 und b3 ist ein Motorschützkontakt 5 geschaltet und mit 4 ist eine Serie Tür- und Schlosskontakte bezeichnet.

Die Anordnung der Vorrichtung gemäss Fig. 2 zeigt, wie die an einer Schachtwand 8 befestigte Betätigungsfahne 2 in die Sicherheitslichtschranke 1 eintaucht, welche seitlich oben an einer Aufzugskabine 7 befestigt ist. Bei abwärtsfahrender Aufzugskabine 7 taucht die Betätigungsfahne 2 von unten her in die Sicherheitslichtschranke 1 ein, wobei der obere waagrechte Rand der Betätigungsfahne 2 die beiden auf einer horizontalen Linie angeordneten Sender S1 und S2 abdeckt und ihre Lichtstrahlen zu den in dieser Figur nicht dargestellten Empfänger E1 und E2 praktisch gleichzeitig unterbricht.

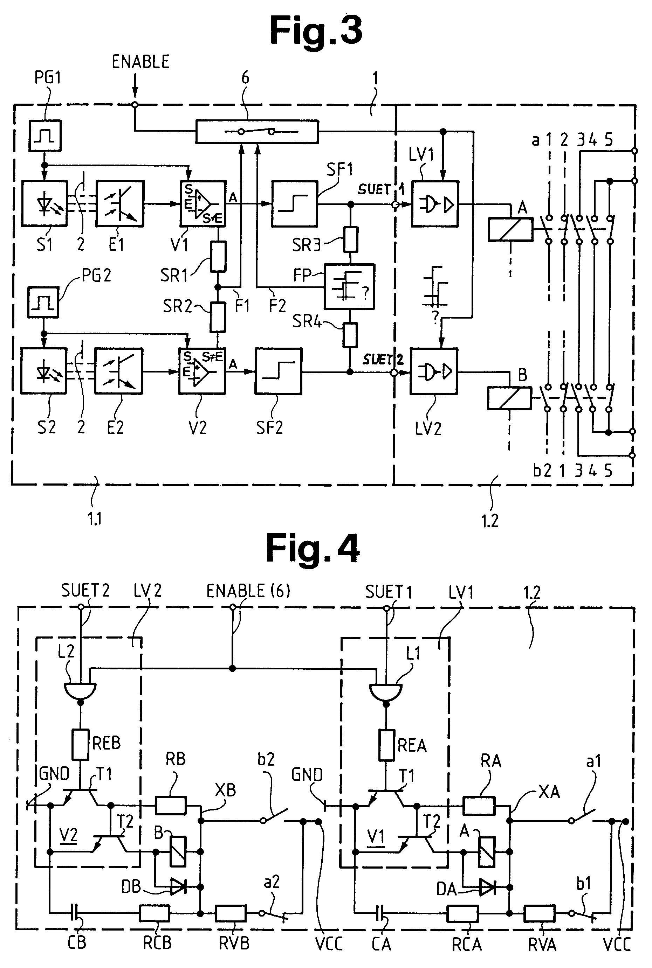

In der Fig. 3 sind die Funktionen der Sicherheitslichtschranke 1 in zwei Hauptgruppen unterteilt, in eine Signalaufbereitung 1.1 und in eine Signalauswertung 1.2. Der Sender S1 ist von einem Pulsgeber PG1 und der Sender S2 von einem Pulsgeber PG2 gespeist. Die Pulsfrequenz von PG1 und E1 ist auf einen Vergleicher V1 mit den Eingängen S und E, und jene von PG2 und E2 auf einen Vergleicher V2, auch mit Eingängen S und E, geführt. Die Ausgänge S ≠ E der beiden Vergleicher V1 und V2 geben bei Frequenzunterschieden zwischen S und E ein Fehlersignal F1, welches einem ENABLE-Unterbrecher 6 zugeführt wird. Die Ausgänge S ≠ E sind zwecks funktioneller Trennung je mit einem hochohmigen Sicherheitswiderstand SR1 und SR2 versehen. Bei vollständigem Ausfall der Empfängerfrequenz an den Eingängen E der Vergleicher V1 und V2 entsteht an ihren Ausgängen A ein Signal, welches zu einem Signalformer SF1 und SF2 geführt wird. Die Ausgangssignale von SF1 und SF2 werden auf ihrem Weg zur Signalauswertung 1.2 von einem hochohmigen Sicherheitswiderstand SR3 und einem hochohmigen Sicherheitswiderstand SR4 abgenommen und auf eine gemeinsame Funktionsprüfung FP geführt, wo sie auf Störfreiheit und Amplitude geprüft werden. Im Fehlerfalle erscheint an ihrem Ausgang ein Fehlersignal F2, das ebenfalls zum ENABLE-Unterbrecher 6 geführt wird.

Die Funktionsgruppe 1.2 enthält je einen Logik- und Verstärkerkreis LV1 und LV2 und die genannten Türsicherheitsrelais A und B mit ihren intern benützten Kontakten a1 und a2 von Türsicherheitsrelais A und Kontakten b1 und b2 von Türsicherheitsrelais B. Die in gleicherweise den entsprechenden Türsicherheitsrelais A und B zugeordneten Kontakte a3, a4 und a5 sowie b3, b4 und b5 sind für Schaltfunktionen im Sicherheitskreis-Teilstück 3 bestimmt. Symbolisierte, zeitlich versetzte Signalsteps mit Fragezeichen geben den Hinweis auf die in der Signalauswertung 1.2 erfolgende Gleichzeitigkeitsprüfung.

Die Kontakte a3, a4 und a5 sind mit den Kontakten b3, b4 und b5 einseitig geradlinig verbunden und auf der anderen Seite, zum Teil gebrückt, an Ausgänge geführt. Die Kontakte a1, a2, b1 und b2 sind Teil einer inneren Verriegelungslogik.

Einzelheiten der Signalauswertung 1.2 sind auf Fig. 4 zu sehen. Zwei NAND-Tore L1 und L2 weisen je zwei Eingänge auf, einen gemeinsamen ENABLE-Eingang, dessen Signal vom ENABLE-Unterbrecher 6 kommt und je einer Signaleingang SUET1 und SUET2, welche von den entsprechenden Signalformern SF1 und SF2 stammen. Der Ausgang der NAND-Tore führt je über einen Eingangswiderstand REA und REB zur Basis eines Transistors T1 im Verstärker V1 und V2. Je ein Transistor T2 ist mit einem Transistor T1 zusammen als zweistufiger Verstärker geschaltet.

Die Transistoren T2 verbinden die Unterseite des Türsicherheitsrelais A bzw. B im leitenden Zustand je mit dem Nullpotential GND. Ein Widerstand RA und ein Widerstand RB sowie eine Diode DA und eine Diode DB sind je parallel zu den Türsicherheitsrelais A und B geschaltet. Je ein Kondensator CA und CB ist mit Widerständen RCA und RVA bzw. mit Widerständen RCB und RVB sowie mit einem Kontakt b1 bzw. a2 zwischen Nullpotential GND und Pluspotential VCC in Serie geschaltet. Ein Leiter XA und ein Leiter XB verbindet je den Punkt zwischen RVA und RCA bzw. zwischen RVB und RCB mit der Kathode der Diode DA bzw. DB, mit der Oberseite des Türsicherheitsrelais A bzw. B, mit dem Widerstand RA bzw. RB und mit der Unterseite des Kontaktes al bzw. b2, dessen Oberseite je mit dem Pluspotential VCC verbunden ist.

Die vorstehend beschriebene Einrichtung arbeitet wie folgt:

Eine Aufzugskabine 7 sei in Fahrt in Abwärtsrichtung. An Stockwerken ohne Kabinenruf und ohne einem dieser Aufzugskabine 7 zugeteilten Stockwerkruf fährt sie vorbei. Beim Vorbeifahren an solchen Stockwerken passiert folgendes: Die Sicherheitslichtschranke 1 wird durch eine Betätigungsfahne 2, welche die Türzone von beispielsweise +/-20 cm beim Stockwerkniveau markiert, unterbrochen und dadurch, dass die Fläche der Betätigungsfahne 2, beginnend mit ihrem waagrechten oberen Rand praktisch gleichzeitig die beiden auf einer horizontalen Linie angeordneten Sender S1 und S2 abdeckt, können die Empfänger E1 und E2 keine Sendefrequenz mehr empfangen, was als Detektion definiert ist. Haben die beiden Vergleicher V1 und V2 vor dem Eintauchen der Betätigungsfahne 2 in die Sicherheitslichtschranke 1 vorher keinen Frequenzfehler zwischen den Eingängen S und E festgestellt, so stellen jetzt beide den praktisch gleichzeitigen Wegfall der Empfängerfrequenz je am Eingang E fest. Diese als Detektion definierte Aenderung der Eingänge E in den Vergleichern V1 und V2 wird im folgenden Signalformerblock SF1 bzw. SF2 invertiert und zum positiven Signalstep aufgearbeitet. Die Ausgangssignale der Signalformer SF1 und SF2 werden je über einen hochohmigen Sicherheitswiderstand SR3 und SR4 zum Funktionsprüfblock FP geführt. Die Redundanz bleibt gewährt, da die hochohmigen Sicherheitswiderstände SR3 und SR4, wie auch SR1 und SR2 keine schädliche Querverbindung ermöglichen.

Der Funktionsprüfblock FP dient der laufenden Signalprüfung bei Stockwerken mit vorbeifahrender Kabine und überwacht Vorhandensein und Gleichzeitigkeit der Signale von SF1 und SF2. Im Fehlerfall wird ein permanent anstehendes Fehlersignal F2 gebildet, welches das für das Zielstockwerk bestimmte ENABLE-Signal blockiert. Ein Fehlersignal F2, wie auch ein Fehlersignal F1 kann nur manuell zurückgestellt werden. Ein Fehlersignal F1 kann von einem einzelnen Vergleicher V1 oder V2 oder von beiden Vergleichern V1 und V2 zusammen erzeugt werden. Das bei Frequenzabweichungen zwischen den Eingängen E und S entstehende Fehlersignal F1 muss ebenfalls, nach Ursachenbehebung, manuell zurückgestellt werden. Eine Rückstellung von Fehlersignalen F1 oder F2 erfolgt üblicherweise durch Aus- und Einschalten der Speisespannung, welche für das ganze System die gleiche ist. Die Spannungsquelle sowie die entsprechende Fehlerspeicher-und Rückstellschaltung sind nicht dargestellt. Beim Zielstockwerk ankommend und in die Türzone einfahrend werden die beiden Signale von SF1 und SF2 nur dann an den Eingängen SUET1 und SUET2 via NAND-Tor zum Eingangswiderstand REA bzw. REB weitergeleitet, wenn das ENABLE-Signal vorhanden ist und dieses nicht im ENABLE-Unterbrecher 6 blockiert ist. Bei fehlendem ENABLE-Signal wird die Aufzugstür erst im Stillstand auf Stockwerkniveau geöffnet.

Im Normalfall werden die beiden NAND-Tore L1 und L2 in den Logik- und Verstärkerkreisen LV1 und LV2 rechtzeitig vor dem Einfahren in die Türzone der Zielhaltestelle mit dem positiven ENABLE-Signal deblockiert. Nun können, beim Eintauchen der Betätigungsfahne 2 in die Sicherheitslichtschranke 1, die beiden positiven Signale via die Eingänge SUET1 und SUET2 die beiden NAND-Tore passieren und via Eingangswiderstände REA und REB die Verstärker V1 und V2 mit den je 2 Transistoren T1 und T2 aussteuern. Im Ruhezustand sind die beiden Kondensatoren CA und CB je annähernd auf das Speisespannungsniveau aufgeladen. Das Aufladen erfolgt via die Widerstände RCA, RVA und den geschlossenen Kontakt b1 für CA und via die Widerstände RCB, RVB und den geschlossenen Kontakt a2 für CB. Ferner sind im Ruhezustand die Transistoren T1 leitend und die Transistoren T2 gesperrt. Die Ohmwerte der Widerstände RCA, RVA und RA bzw. RCB, RVB und RB verhalten sich zueinander in einem Verhältnis von beispielsweise 1 zu 10 zu 200. Daraus ergibt sich, unter Berücksichtigung der Spannungsteilung zwischen RVA und RA bzw. zwischen RVB und RB, des Spannungsabfalles über T1 und dem zum Ladestrom parallel fliessenden Ableitstrom über RA und T1 bzw. RB und T1 auf dem Leiter XA bzw. XB, eine Spannung von ca. 95 % VCC. Beim Öffnen des Kontaktes b1 bzw. a2 entlädt sich der Kondensator CA via RCA, RA und T1 und der Kondensator CB via RCB, RB und T1 mit einer entsprechenden Zeitkonstante R mal C. Wenn sich die Betätigungsfahne 2 beim Einfahren in die Türzone vor die Sender S1 und S2 schiebt, erfolgt deren Abdeckung nicht im genau gleichen Zeitpunkt, weil, gegeben durch mechanische Toleranzen, ein Synchronismus nicht zwangsläufig ist. Ferner sind die Signallaufzeiten bis und mit Anziehen des entsprechenden Türsicherheitrelais A oder B, gegeben durch Bauteiletoleranzen, auch nicht zwangsläufig gleichlang. Daraus folgt, dass nur ein einziges Türsicherheitsrelais, A oder B, zuerst anzieht. Das erste angezogene Türsicherheitsrelais öffnet mit seinem Kontakt b1 bzw. a2 beim zweiten Türsicherheitsrelais den Ladestromkreis des Kondensators CB oder CA, startet damit dessen Entladung und macht mit seinem Kontakt a1 bzw. b2 Selbsthaltung. Das zweite Türsicherheitsrelais muss nun innerhalb der beispielsweise ersten Hälfte der Entladezeitkonstante CB mal RCB plus RB bzw. CA mal RCA plus RA angesteuert werden, um auch noch anziehen zu können. Die daraus resultierende Zeitspanne ist als Testzeit definiert. Dieser Vorgang ist die Funktion der Gleichzeitigkeitsprüfung. Kommen die zwei Detektionssignale von E1 und E2 nicht innerhalb einer vorgegebenen Zeitspanne, so können nicht beide Türsicherheitsrelais anziehen. Ist beim Entriegeln der Tür beim Einfahren nur ein einziges Türsicherheitsrelais A oder B angezogen, so wird, infolge eines geöffneten Schlosskontaktes in der Serie der Tür- und Schlosskontakte 4 der Sicherheitskreis selbst geöffnet, was einen Notstop des Aufzuges in der Nähe des Stockwerkniveaus zur Folge hat. Dieser Notstop kann vermieden werden, wenn je ein weiterer nicht dargestellter Schliesskontakt der Türsicherheitsrelais A und B in Serie geschaltet der Aufzugssteuerung bei korrekter Funktion ein Bereitschaftssignal zum Türöffnen geben bzw. im Fehlerfall das Türöffnen erst im Stillstand des Aufzugs via Aufzugssteuerung freigeben.

Würde beispielsweise ein Türsicherheitsrelais, bzw. einer seiner Kontakte verschweissen, so kann das nächste Mal das zweite Türsicherheitsrelais nicht mehr anziehen. Dies deshalb, weil das verschweisste Relais mechanisch im angezogenen Zustand bleibt und so mit seinem Ruhekontakt b1 oder a2 den Ladestromkreis für den Kondensator des zweiten Türsicherheitsrelais offen hält. Dadurch bleibt der entsprechende Kondensator sicher entladen und ein Anziehen des zweiten Türsicherheitsrelais ist beim nächsten Zielhalt nicht möglich, was die vorgängig beschriebenen Folgen hat.

In einer weitergebildeten Form ist es möglich, weitere parallel und unabhängig arbeitende optoelektronische Detektionssysteme in derselben Sicherheitslichtschranke 1 einzubauen. Dabei würden diese weiteren Detektionssysteme getrennt Signale für weitere Zwecke an die Aufzugssteuerung abgeben.

Die weiteren Detektionssysteme bzw. ihre Sensoren können auch vertikal angeordnet werden, wobei diese, kombiniert mit entsprechend positionierten Öffnungen in den Betätigungsfahnen 2, zusätzlich als Nachregulierfotozelle und Niveaudetektor dienen würden.

## Patentansprüche

1. Verfahren zur Erzeugung einer Schachtinformation bei Aufzügen für die redundante und selbstprüfende Bildung von Signalen und Auslösung von Schaltfunktionen zwecks Ueberbrückung von Tür- und Schlosskontakten (4) in der Türzone einer Zielhaltestelle bei in diese Haltestelle einfahrendem Aufzug
dadurch gekennzeichnet,
dass die Ueberbrückung der Tür- und Schlosskontakte (4) durch Relaiskontakte (a3,4,5 und b3,4,5) von mehreren in einer Sicherheitslichtschranke (1) eingebauten Türsicherheitsrelais (A und B) erfolgt,
dass die Funktion und die Funktionsbereitschaft einer Signalaufbereitung (1.1) bei auf irgend einer Haltestelle ohne Fahrbefehl stehendem Aufzug, beim Vorbeifahren des Aufzuges an einer Haltestelle ohne Haltbefehl und beim Einfahren in eine Haltestelle mit Haltbefehl an mindestens einer Stelle in der Signalaufbereitung (1.1) getestet und bei Fehlererkennung Fehlersignale (F1,F2) erzeugt werden,
dass in einer Signalauswertung (1.2) beim Einfahren in eine Haltestelle mit Haltbefehl eine Gleichzeitigkeitsprüfung der aus Signalformern (SF1 und SF2) der Signalaufbereitung (1.1) kommenden, an den Eingängen (SUET1 und SUET2) der Signalauswertung (1.2) anliegenden und für das Anziehen der Türsicherheitsrelais (A und B) verantwortlichen Signale erfolgt, indem von einem ersten angezogenen Türsicherheitsrelais (A oder B) eine Testzeit gestartet wird, und indem das zweite Türsicherheitsrelais (A oder B) für eine Ueberbrückung der Tür- und Schlosskontakte (4) innerhalb dieser Testzeit anziehen muss, und wobei bei Testzeitüberschreitung ein Anziehen des zweiten Türsicherheitsrelais (A oder B) und ein vorzeitiges Türöffnen verhindert wird, und
dass das Anziehen der Türsicherheitsrelais (A und B) beim Vorbeifahren an Haltestellen ohne Haltbefehl blockiert wird.

2. Verfahren nach Anspruch 1,
**dadurch gekennzeichnet,**
dass erkannte Fehler als Fehlersignale (F1, F2) gespeichert werden und manuelle Rückstellung erfordern und dass erkannte Fehler mittels den Fehlersignalen (F1, F2) in der Signalaufbereitung (1.1) einen ENABLE-Unterbrecher (6) aktivieren.

3. Verfahren nach Ansprüchen 1 und 2,
**dadurch gekennzeichnet**,
dass zum Testen der Funktionsbereitschaft in einem ersten Vergleicher (V1) die Pulsfrequenz eines ersten Senders (S1) mit jener eines ersten Empfängers (E1) und in einem zweiten Vergleicher (V2) die Pulsfrequenz eines zweiten Senders (S2) mit jener eines zweiten Empfängers (E2) verglichen und im Fehlerfall ein erstes Fehlersignal (F1) gebildet und der gleichzeitige Wegfall beider Empfängerfrequenzen als Detektion einer Betätigungsfahne (2) interpretiert wird.

4. Verfahren nach Ansprüchen 1 und 2,
**dadurch gekennzeichnet**,
dass zum Testen der Funktion die zwei beim Ein- und Austauchen einer Betätigungsfahne (2) in der Sicherheitslichtschranke (1) erzeugten und von den Signalformern (SF1 und SF2) kommenden digitalen Signale je in einen Funktionsprüfblock (FP) geführt und dort auf ihre zeitliche und qualitative Erscheinungsform geprüft werden und im Fehlerfall ein zweites Fehlersignal (F2) gebildet wird.

5. Vorrichtung zur Durchführung des Verfahrens nach Anspruch 1 in der Form einer Sicherheitsschranke (1), bestehend aus einer Funktionsgruppe Signalaufbereitung (1.1) und einer Funktionsgruppe Signalauswertung (1.2), wobei die Signalaufbereitung (1.1) mindestens zwei, von einem Pulsgeber (PG1,PG2) gespeiste Sender (S1,S2) und mindestens zwei, auf die Sender (S1,S2) ausgerichtete Empfänger (E1,E2) aufweist und wobei mindestens zwei, mit den Empfängerausgängen und den Pulsgebern (PG1,PG2) verbundene Vergleicher (V1,V2) vorhanden sind, und wobei die Ausgänge S ≠ E der Vergleicher (V1,V2) mit hochohmigen Sicherheitswiderständen (SR1,SR2) verbunden sind, deren gemeinsamer Punkt, via eine das Fehlersignal F1 übermittelnde Verbindung, zu einem ENABLE-Unterbrecher (6) führt, und wobei die Ausgänge A der Vergleicher (V1,V2) mit Signalformern (SF1,SF2) verbunden sind, deren Ausgänge einerseits via hochohmige Schutzwiderstände (SR3,SR4) zu einem Funktionsprüfblock (FP) führen, dessen Ausgang, via eine das Fehlersignal F2 übermittelnde Verbindung, zum ENABLE-Unterbrecher (6) führt, und wobei die Ausgänge der Signalformer (SF1,SF2) einerseits Ausgänge der Signalaufbereitung (1.1) und anderseits Eingänge (SUET1, SUET2) der nachfolgenden Signalauswertung (1.2) bilden, in welcher sie in mindestens zwei Logik- und Verstärkerkreisen (LV1,LV2) zusammen mit dem Ausgang des ENABLE-Unterbrechers (6) jeweils auf ein NAND-Tor (L1,L2) führen, dessen Ausgang jeweils via einem Eingangswiderstand (REA,REB) mit einem zweistufigen Verstärker (V1,V2) bestehend aus zwei Transistoren (T1 und T2) und einem zwischen dem Transistor (T1) und einem Punkt XA,XB liegenden Widerstand (RA,RB) verbunden ist, dessen Ausgang jeweils zu einer mit einer Diode (DA,DB) beschalteten Spule eines Relais (A,B) mit Kontakten a1-a5 bzw. b1-b5 führt, wobei die Kontakte a1, b2 als Selbsthaltekontakte geschaltet sind, und wobei jeweils eine mit Masse (GND) und dem Punkt XA,XB verbundene Testzeitschaltung, bestehend aus Kondensator (CA,CB) und Widerstand (RCA,RCB) und eine mit der jeweiligen Spule und mit dem Pluspotential (VCC) verbundene Ladeschaltung, bestehend aus einem Widerstand (RVA,RVb) und Kontakt b1, bzw. a2 vorhanden sind, und wobei die Kontakte a3,b3 seriell mit einem externen Motorschutzkontakt (5), die Kontakte a4,b4 und a5,b5 je in Serie und zueinander parallel und zu den Kontakten a3,b3 parallel geschaltet sind und wobei die Kontakte a3-a5 und b3-b5 innerhalb eines Sicherheitskreis-Teilstückes (3) parallel zu Türkontakten (4) geschaltet sind.

## Claims

1. Method for the production of a shaft information in lifts for the redundant and self-checking formation of signals and initiation of switching functions for the purpose of the bridging of door and lock contacts (4) in the door zone of a destination stop when the lift is arriving at this stop, characterised thereby, that the bridging of door and lock contacts (4) takes place through relay contacts (a3, 4; 5) and b3, 4, 5) of several door safety relays (A and B) installed in a safety light barrier (1), that the function and the readiness for function of a signal-preparing device (1.1) are tested at at least one point in the signal-preparing device (1.1) and fault signals (F1, F2) are generated on fault recognition in the case of a lift standing without travel command at a stop, in the case of the lift travelling without stop command past a stop and in the case of arriving with stop command at a stop, that a coincidence test of the signals, which came from the signal shapers (SF1 and SF2) of the signal-preparing device (1.1), are present at the inputs (SUET1 and SUET2) of a signal-evaluating device (1.2) and which are responsible for the energising of the door safety relays (A and B), takes place in the signal-evaluating device (1.2) on arriving with stop command at a stop in that a testing period is started by a first energised door safety relay (A or B) and in that the second door safety relay (A and B) must become energised within this testing period for a bridging of door and lock contacts (4) and wherein an energising of the second door safety relay (A or B) and a premature door opening are prevented when the testing period is exceeded and that the energising of the door safety relays (A and B) is blocked in the case of travelling without stop command past a stop.

2. Method according to claim 1, characterised thereby, that recognised faults are stored as fault signals (F1, F2) and require manual resetting and that recognised faults activate an ENABLE interrupter (6) in the signal-preparing device (1.1) by means of the fault signals.

3. Method according to claims 1 and 2, characterised thereby, that for the testing of the readiness for function, the pulse frequency of a first transmitter (S1) is compared with that of a first receiver (E1) in a first comparator (V1) and the pulse frequency of a second transmitter (S2) is compared with that of a second receiver (E2) in a second comparator (V2) and, in the case of a fault, a first fault signal (F1) is formed and the simultaneous absence of both receiver frequencies is interpreted as detection of an actuating flag (2).

4. Method according to claims 1 and 2, characterised thereby, that for the testing of the function, the two digital signals, which are produced in the safety light barrier (1) on the entry and the emergence of an actuating flag (2) and come from the signal shapers, are each led into a function-testing block (FP) and tested there for their temporal and qualitative form of appearance and, in the case of a fault, a second fault signal (F2) is formed.

5. Device for the performance of the method according to claim 1, in the form of a safety light barrier (1), which device consists of a functional group for signal preparation (1.1) and of a functional group for signal evaluation (1.2), wherein the signal-preparing group (1.1) comprises at least two transmitters (S1, S2) fed by a pulse generator (PG1, PG2) and at least two receivers (E1, E2) aligned to the transmitters (S1, S2) and wherein at least two comparators (V1, V2) are present, which are connected with the receiver outputs and the pulse generators (PG1, PG2), wherein the outputs (S≠E) of the comparators (V1, V2) are connected with safety resistors (SR1, SRS) of high value and their common point leads to an ENABLE interrupter (6) by way of a connection communicating the fault signal (F1), wherein the outputs (A) of the comparators (V1, V2) are connected with signal shapers (SF1, SF2), the outputs of which on the one hand lead by way of protective resistors (SR3, SR4) of high value to a function-testing block (FP), the output of which leads to the ENABLE interrupter (6) by way of a connection communicating the one fault signal (F2), wherein the outputs of the signal shapers (SF1, SF2) form on the one hand outputs of the signal-preparing device (1.1) and on the other hand inputs (SUET1, SUET2) of the following signal-evaluating group (1.2), in which they lead in at least two logic and amplifier circuits (LV1, LV2) together with the output of the ENABLE interrupter (6) each to a respective NAND gate (L1, L2), the output of which is connected each time by way of an input resistor (REa, REB) with a two-stage amplifier (V1, V2), which consists of two transistors (T1 and T2) and a resistor (RA, RB) lying between the transistor (T1) and a point XA, XB and the output of which each time leads to a coil which belongs to a relay (A, B) with contacts (a1 to a5 and b1 to b5) and has a diode (DA, DB) connected across it, wherein the contacts (a1, b2) are wired as holding contacts, wherein a test period circuit, which is connected with ground (GND) and the point (XA, XB) and consists of a capacitor (CA, CB) and a resistor (RCA, RCB), and a charging circuit, which is connected with the respective coil and the positive potential (VCC or a2) and consists of a resistor (RVA, RVB) and the contact (b1), are present each time, wherein the contacts (a3, b3) are wired in series with an external motor relay contact (5), the contacts (a4, b4) and the contacts (a5, b5) are each connected in series and in parallel one to the other and to the contacts (a3, b3) and wherein the contacts (a3 to a5 and b3 to b5) are wired in parallel with the door contacts (4) within a safety circuit part (3).

## Revendications

1. Procédé pour générer une information de cage d'ascenseur destinée à la formation redondante et d'autocontrôle de signaux et au déclenchement de fonctions de commutation, en vue du court-circuitage de contacts de porte et de serrure (4) dans la zone de la porte d'un arrêt de destination quand un ascenseur arrive à cet arrêt, caractérisé
en ce que le court-circuitage des contacts de porte et de serrure (4) se fait grâce à des contacts (a3, 4, 5 et b3, 4, 5) de plusieurs relais de sécurité de porte (A et B) montés dans une cellule photo-électrique de sécurité (1),
en ce que, lorsque l'ascenseur se trouve à n'importe quel arrêt sans ordre de marche, lors de son passage à un arrêt sans ordre d'arrêt et lors de l'arrivée à un arrêt avec un ordre d'arrêt, la fonction et la disponibilité de fonctionnement d'une préparation de signaux (1.1) sont testées à un ou plusieurs endroits de la préparation de signaux (1.1), et des signaux d'erreur (F1, F2) sont générés en cas de détection d'erreur,
en ce qu'un contrôle de simultanéité des signaux provenant des éléments de formation de signaux (SF1 et SF2) de la préparation de signaux (1.1), présents aux entrées (SUET1 et SUET2) d'une exploitation de signaux (1.2) et responsables de l'actionnement des relais de sécurité de porte (A et B), a lieu dans ladite exploitation de signaux (1.2) lors de l'arrivée à un arrêt avec ordre d'arrêt, un temps de test étant démarré par un premier relais de sécurité de porte actionné (A ou B), tandis que le second relais de sécurité de porte (A ou B) doit procéder à un actionnement pour un court-circuitage des contacts de porte et de serrure (4) à l'intérieur de ce temps de test, étant précisé qu'en cas de dépassement du temps de test, un actionnement du second relais de sécurité de porte (A ou B) et une ouverture de porte anticipée sont empêchés, et
en ce que l'actionnement des relais de sécurité de porte (A et B) est bloqué lors du passage à des arrêts sans ordre d'arrêt.

2. Procédé selon la revendication 1, caractérisé en ce que des erreurs détectées sont mises en mémoire sous la forme de signaux d'erreurs (F1, F2) et nécessitent une remise à zéro manuelle, et en ce que des erreurs détectées activent dans la préparation de signaux (1.1) un interrupteur ENABLE (6) à l'aide des signaux d'erreurs (F1, F2).

3. Procédé selon les revendications 1 et 2, caractérisé en ce que, pour le test de la disponibilité de fonctionnement, la fréquence de répétition des impulsions d'un premier émetteur (S1) est comparée dans un premier comparateur (V1) à celle d'un premier récepteur (E1), et la fréquence de répétition d'impulsions d'un second émetteur (S2) est comparée dans un second comparateur (V2) à celle d'un second récepteur (E2), et en cas d'erreur, un premier signal d'erreur (F1) est formé et la suppression simultanée des deux fréquences de récepteurs est interprétée comme détection d'une queue d'actionnement (2).

4. Procédé selon les revendications 1 et 2, caractérisé en ce que, pour le test de la fonction, les deux signaux numériques générés lors de la pénétration d'une queue d'actionnement (2) dans la cellule photo-électrique de sécurité (1) et de sa sortie, et provenant des éléments de formation de signaux (SF1 et SF2) sont transmis à un bloc de contrôle de fonction (FP) dans lequel leurs formes temporelle et qualitative sont contrôlées et, en cas d'erreur, un second signal d'erreur (F2) est généré.

5. Dispositif pour mettre en oeuvre le procédé selon la revendication 1, se présentant sous la forme d'une cellule photo-électrique de sécurité (1) et composé d'un groupe de fonction de préparation de signaux (1.1) et d'un groupe de fonction d'exploitation de signaux (1.2), étant précisé que la préparation de signaux (1.1) comporte au moins deux émetteurs (S1, S2) alimentés par un générateur d'impulsions (PG1, PG2), et au moins deux récepteurs (E1, E2) orientés vers les émetteurs (S1, S2), qu'il est prévu au moins deux comparateurs (V1, V2) reliés aux sorties de récepteurs et aux générateurs d'impulsions (PG1, PG2), que les sorties S ≠ E des comparateurs (V1, V2) sont reliées à des résistances de sécurité à grande résistance (SR1, SR2) dont le point commun mène à un interrupteur ENABLE (6) par l'intermédiaire d'une liaison transmettant le signal d'erreur (F1), que les sorties A des comparateurs (V1, V2) sont reliées à des éléments de formation de signaux (SF1, SF2) dont les sorties mènent, d'un côté, par l'intermédiaire de résistances de protection à grande résistance (SR3, SR4), à un bloc de contrôle de fonction (FP) dont la sortie mène à l'interrupteur ENABLE (6) par l'intermédiaire d'une liaison transmettant le signal d'erreur F2, et que les sorties des éléments de formation de signaux (SF1, SF2) définissent d'une part des sorties de la préparation de signaux (1.1) et d'autre part des entrées (SUET1, SUET2) de l'exploitation de signaux (1.2) qui suit, dans laquelle elles mènent, dans au moins deux circuits logique et amplificateur (LV1, LV2), avec la sortie de l'interrupteur ENABLE (6), à des portes NON-ET respectives (L1, L2) dont la sortie est reliée, par l'intermédiaire d'une résistance d'entrée (REA, REB), à un amplificateur à deux étages (V1, V2) qui est formé de deux transistors (T1 et T2) et d'une résistance (RA, RB) placée entre le transistor (T1) et un point XA, XB, et dont la sortie mène à une bobine, branchée à une diode (DA, DB), d'un relais (A, B) comportant des contacts (a1-a5, b1-b5), étant précisé que les contacts (a1, b2) sont montés comme des contacts d'auto-entretien, qu'il est prévu, relié à la masse (GND) et au point XA, XB, un circuit de temps de test formé d'un condensateur (CA, CB) et d'une résistance (RCA, RCB), ainsi qu'un circuit de charge relié à la bobine et au potentiel positif (VCC) et formé d'une résistance (RVA, RVb) et du contact b1, a2, que les contacts a3, b3 sont reliés en série à un contact de protection de moteur externe (5) tandis que les contacts a4, b4 et a5, b5 sont montés en série et parallèlement les uns aux autres et parallèlement aux contacts a3, b3, et enfin que les contacts a3-a5 et b3-b5 sont montés parallèlement à des contacts de porte (4) à l'intérieur d'une section de circuit de sécurité (3).
